# DEMANDE DE BREVET EUROPEEN

(11) **EP 4 752 050 A1**
(43) Date de publication de la demande: **03.06.2026**
(21) Numéro de dépôt: 25196631.3
(22) Date de dépôt: 19.08.2025
(51) Int. Cl.: B64C 13/50, B64C 27/00, B64C 27/57

(54) **CHAINE MECANIQUE DE COMMANDE DE VOL D'UN AERONEF AVEC MESURE D'UN EFFORT DANS LA CHAINE MECANIQUE DE COMMANDE DE VOL**

(30) Priorité: 28.11.2024 FR 2413153
(71) Demandeur: Airbus Helicopters, 13725 Marignane Cedex (FR)
(72) Inventeur: LETONNELIER, Clément, 13580 LA FARE LES OLIVIERS (FR); IZZO, Pascal, 13130 BERRE L'ETANG (FR); MAUSSION, Antoine, 13580 LA FARE LES OLIVIERS (FR)
(74) Mandataire: GPI Brevets

(57) **Abrégé**

La présente invention concerne une chaîne mécanique de commande de vol (2) d'un aéronef munie d'un actionneur (30) et d'un système de mesure d'effort (40), ledit actionneur (30) comportant au moins un moteur électrique et un calculateur duplex par moteur, chaque calculateur duplex comportant une voie de commande, une voie de surveillance et deux interfaces d'entrée, ledit système de mesure d'effort (40) comportant plusieurs voies de mesure comprenant chacune un capteur, un module électronique et une interface de sortie reliée à une desdites interfaces d'entrée. Ledit module électronique est relié audit capteur pour générer un signal analogique de mesure et est configuré pour effectuer une numérisation dudit signal analogique de mesure, au moins une desdites voies de mesure appliquant une modulation delta-sigma, puis pour le transformer en un signal numérique de transfert porteur d'une valeur de transfert représentative d'un effort dans ladite chaîne mécanique de commande de vol (2).

## Description

La présente invention se situe dans le domaine des commandes de vol des aéronefs.

La présente invention concerne une chaîne mécanique de commande de vol d'un aéronef comportant un système de mesure d'effort et un aéronef équipé de cette chaîne mécanique de commande de vol. La présente invention vise aussi un procédé de mesure d'une valeur représentative d'un effort dans une chaîne mécanique de commande de vol d'un aéronef.

Un aéronef peut comporter des gouvernes aérodynamiques mobiles pilotées par un système de commande de vol mécanique pour diriger l'aéronef. De telles gouvernes aérodynamiques peuvent comprendre des pales de rotor, des pales d'hélices, des volets de profondeur ou de direction par exemple.

Une chaîne mécanique de commande de vol peut comporter plusieurs bielles formant une tringlerie entre un organe de pilotage, tel un levier, un manche ou un palonnier, et une gouverne aérodynamique à déplacer, éventuellement par l'intermédiaire d'une servocommande. Une chaîne mécanique de commande de vol peut aussi comporter un ou plusieurs actionneurs.

Par exemple, un actionneur série peut être intercalé entre deux bielles de la chaîne mécanique de commande de vol, un allongement ou une rétraction de cet actionneur série provoquant un changement de l'ordre transmis à la servocommande sans avoir d'effet sur la position de l'organe de pilotage.

Selon un autre exemple, un actionneur parallèle, dit également « actionneur de trim », peut relier l'organe de pilotage ou une bielle de la chaîne mécanique de commande de vol à un point fixe de la structure de l'aéronef. Un tel actionneur parallèle peut par exemple provoquer des changements simultanés de l'ordre transmis à la servocommande et de la position de l'organe de pilotage. Cet actionneur parallèle peut aussi permettre d'ancrer l'organe de pilotage dans une position déterminée. Un tel actionneur parallèle peut aussi faire office de butée douces ou franches pour indiquer notamment à un pilote l'atteinte et/ou le dépassement d'une limite de vol, voire un retour haptique.

En outre, afin d'atteindre le niveau de sécurité requis, ces actionneurs peuvent comporter deux moteurs, pilotés respectivement par des calculateurs duplex distincts, voire dissimilaires. De tels calculateurs duplex comporte ainsi une première voie de calcul dédiée à la commande des mouvements de l'actionneur et une seconde voie de calcul dédiée à la surveillance de la première voie de calcul, et permettant le cas échéant de l'inhiber en cas de détection d'une anomalie ou d'une panne.

Quel que soit leur type, ces actionneurs peuvent être asservis en fonction d'un effort. Dans ce but, et pour adapter la consigne de commande des actionneurs, une mesure d'effort dans la chaîne mécanique de commande de vol, et en particulier sur une bielle, est nécessaire.

Un ou plusieurs dispositifs de mesure d'effort de type analogique peuvent, par exemple, être intégrés sur une chaîne mécanique de commande de vol comme décrit dans le document EP 3301019. De tels dispositifs de mesure d'effort peuvent être particulièrement sensibles aux environnements contraints. De plus, ces dispositifs de mesure d'effort peuvent induire une friction non négligeable sur les organes de pilotage due aux nombreux fils de liaison électrique de ces dispositifs.

Par ailleurs, le signal fourni par un dispositif de mesure d'effort agencé sur une chaîne mécanique de commande de vol peut être traité et/ou filtré afin d'améliorer sa résolution ou de limiter son bruit par exemple. Un signal analogique peut aussi être transformé en un signal numérique comme décrit, par exemple, dans le document US2014/0266259.

Pour répondre à un niveau de sécurisation important attaché à une chaîne mécanique de commande de vol d'un aéronef, un tel dispositif de mesure d'effort agencé sur la chaîne mécanique de commande de vol peut être de type duplex, à savoir comportant deux voies de mesure indépendantes, voire quadruplex, à savoir comportant quatre voies de mesure indépendantes. En particulier, l'utilisation d'un dispositif de mesure d'effort quadruplex permet d'atteindre un taux d'occurrence de panne inférieur ou égal à 10⁻⁶/ heure de vol pour une perte d'une ou de plusieurs voies de mesure du dispositifs de mesure d'effort ainsi qu'un taux d'occurrence de panne inférieur ou égal à 10⁻¹⁰/heure de vol pour l'émission d'un signal erroné non détectée sur une ou plusieurs voies de mesure et pour une défaillance mécanique amenant à une perte de l'organe de commande.

En outre, les documents US 2019/0233087, US 2019/0300169, EP 0606469 et US 2022/0380023 ainsi que la publication de Holger FLÜHR, "Avionik und Flugsicherungstechnik: Einführung in Kommunikationstechnik, Navigation, Surveillance" (2013-02-06), XP055488213 sont aussi connus.

La présente invention a alors pour objet un procédé innovant de mesure d'un effort dans une chaîne mécanique de commande de vol d'un aéronef. La présente invention a aussi pour objets une chaîne mécanique de commande de vol comportant un capteur d'effort susceptible d'appliquer un tel procédé et un aéronef comportant une telle chaîne mécanique de commande de vol.

La présente invention vise ainsi une chaîne mécanique de commande de vol d'un aéronef comportant au moins une bielle et un actionneur, l'actionneur comportant au moins un moteur électrique et un calculateur duplex par moteur, chaque calculateur duplex comportant une voie de commande, une voie de surveillance et deux interfaces d'entrée reliées respectivement à la voie de commande et à la voie de surveillance. La chaîne mécanique de commande de vol comporte également un système de mesure d'effort agencé sur la bielle et configuré pour contrôler l'actionneur. Les voies de commande et de surveillance de chaque calculateur duplex constituent des voies de calcul de ce calculateur duplex.

La chaîne mécanique de commande de vol est remarquable en ce que le système de mesure d'effort comporte au moins deux voies de mesure reliées respectivement aux deux interfaces d'entrée dudit au moins un calculateur duplex et chacune desdites voies de mesure comporte un capteur, un module électronique et une interface de sortie. L'interface de sortie est reliée à une des interfaces d'entrée dudit au moins un calculateur duplex, le module électronique étant relié au capteur pour générer un signal analogique de mesure, le module électronique étant configuré pour effectuer une numérisation du signal analogique de mesure pour le transformer en un signal numérique de mesure, le module électronique étant configuré pour effectuer une transformation du signal numérique de mesure en un signal numérique de transfert porteur d'une valeur de transfert représentative d'un effort dans la chaîne mécanique de commande de vol. Au moins une des voies de mesure applique une modulation delta-sigma pour numériser le signal analogique de mesure et applique un codage Manchester et une transmission différentielle basse-tension pour transformer le signal numérique de mesure pour obtenir le signal numérique de transfert, la chaîne mécanique de commande de vol comportant une horloge par voie de mesure destinée à cadencer la modulation delta-sigma.

La chaîne mécanique de commande de vol peut être reliée à une de ses extrémités à un organe de pilotage, tel un manche, un levier ou un palonnier par exemple, et à une autre de ses extrémités à une gouverne aérodynamique de l'aéronef, telle qu'une ou des pales d'un rotor ou un ou des volets par exemple, éventuellement par l'intermédiaire d'une servocommande.

Le module électronique peut comporter un circuit imprimé portant des composants électroniques tels que des circuits intégrés et/ou des microcontacts. Ce module électronique n'applique pas dans ce cas de programme stockés dans une mémoire pour réaliser les étapes du procédé.

Alternativement, le module électronique peut comporter un calculateur, par exemple un microcontrôleur, et une mémoire stockant un programme appliqué par le calculateur pour réaliser les étapes du procédé.

Le signal analogique de mesure est porteur d'une valeur mesurée par le capteur, cette valeur mesurée étant fonction d'un effort subi ou transmis par la chaîne mécanique de commande de vol, et en particulier par la bielle de cette chaîne mécanique de commande de vol.

La modulation delta-sigma permet de transformer la valeur mesurée acquise sous forme analogique en une valeur numérisée portée par le signal numérique de mesure. Ce signal numérique de mesure est codé sur un ou plusieurs bits, par sur-échantillonnage, dont le taux de variation, compris entre 0 et 1, est fonction de l'amplitude du signal analogique de mesure. Cette modulation delta-sigma est cadencée par l'horloge relative à la voie de mesure concernée. L'utilisation du signal temporel émis par cette horloge ainsi que la fréquence de ce signal temporel influent sur la résolution des signaux numériques de mesure et de transfert, ainsi que sur leur précision. Cette valeur numérisée portée par le signal numérique de mesure est fonction de la valeur mesurée et donc également de l'effort subi ou transmis par la chaîne mécanique de commande de vol.

Ensuite, le codage Manchester et la transmission différentielle basse-tension, connue sous l'acronyme *« LVDS »* pour la désignation en langue anglaise « Low Voltage Differential Signaling », permettent de transformer la valeur numérisée portée par le signal numérique de mesure en la valeur de transfert portée par le signal numérique de transfert. Le codage Manchester est un codage synchrone qui présente l'avantage de transmettre au travers de cet unique signal numérique de transfert la valeur de transfert ainsi que le signal temporel fourni par l'horloge. A chaque cycle d'horloge, un bit est encodé soit par une transition 0 vers 1 ou de 1 vers 0 à mi-cycle selon que le bit à encoder est un « 1 » ou un « 0 », permettant ainsi la reconstitution de l'horloge par le récepteur du signal numérique de transfert.

De plus, la transmission différentielle basse-tension présente l'avantage d'être plus immune au bruit électrique, de supporter des signaux de fréquences plus importantes et de parcourir des distances plus longues que des couches physiques de type *TTL* pour la désignation en langue anglaise « Transistor-Transistor Logic ». La transmission différentielle basse-tension nécessite en outre l'utilisation de fils torsadés et de protections contre la foudre plus petites.

La valeur de transfert portée par le signal numérique de transfert est ainsi fonction de la valeur numérisée et donc également de l'effort subi ou transmis par la chaîne mécanique de commande de vol.

Cette chaîne mécanique de commande de vol permet donc avantageusement, par les traitements appliqués successivement au signal analogique de mesure et au signal numérique de mesure qu'une valeur de transfert précise, peu sensible notamment aux perturbations électromagnétiques, et représentative de l'effort dans la chaîne mécanique de commande de vol soit transmise à l'actionneur afin de le contrôler de façon optimale.

Cet actionneur peut être, par exemple, un actionneur série reliant deux bielles de la chaîne mécanique de commande de vol. Cet actionneur peut aussi être un actionneur parallèle reliant l'organe de pilotage ou une bielle de la chaîne mécanique de commande de vol à un point fixe de la structure de l'aéronef. L'actionneur peut être hydraulique, pneumatique ou électrique. La chaîne de commande de vol permet ainsi de piloter les mouvements d'une gouverne aérodynamique, en contrôlant par exemple le pas de pales ou l'orientation de volets, éventuellement par l'intermédiaire de la servocommande.

La chaîne mécanique de commande de vol selon l'invention peut de plus comporter une ou plusieurs des caractéristiques qui suivent, prises seules ou en combinaison.

Selon une possibilité, le capteur peut comporter au moins une jauge de contraintes, un capteur piézo-électriques ou un capteur de déplacement linéaires connu sous l'acronyme « *LVDT* » pour la désignation en langue anglaise « Linear Variable Differential Transformer ». Ce capteur permet alors de mesurer un déplacement ou une déformation de la bielle qui est fonction de l'effort subi ou transmis par cette bielle dans la chaîne de commande de vol entre l'organe de commande et la servocommande d'une gouverne aérodynamique.

Chaque voie de mesure peut comporter un capteur de même type. Alternativement, au moins deux voies de mesure peuvent comporter respectivement des capteurs de types différents, pour contribuer à une dissimilarité de ces au moins deux voies de mesure.

Selon une possibilité compatible avec les précédentes, le système de mesure d'effort peut comporter les horloges. En particulier, le module électronique de chaque voie de mesure peut comporter une horloge, garantissant ainsi l'indépendance de chacune des voies de mesure.

Alternativement, l'actionneur peut comporter les horloges. En particulier, un calculateur duplex de cet actionneur peut comporter une telle horloge sur chacune des voies de commande et de surveillance. Le signal temporel de chaque horloge est alors transmis aux voies de mesure du système de mesure d'effort, par l'intermédiaire des interfaces d'entrée et de sortie. En conséquence, le système de mesure d'effort peut être simplifié, plus léger et moins couteux lorsqu'il ne comporte pas une telle horloge.

Selon une possibilité compatible avec les précédentes, pour au moins une des voies de mesure, le module électronique peut comporter un convertisseur analogique vers numérique pour numériser le signal analogique et l'interface de sortie comporte un bus numérique.

La ou les voies de mesure comportant un tel convertisseur analogique vers numérique sont une ou des voies de mesure n'appliquant pas la modulation delta-sigma.

Avantageusement, le traitement du signal analogique de mesure est ainsi effectué de façon dissimilaire par au moins deux voies de mesure, au moins une voie de mesure appliquant la modulation delta-sigma et au moins une voie de mesure appliquant une conversion analogique vers numérique.

De la sorte, au moins deux voies de mesure sont dissimilaires, au moins par la méthode de numérisation utilisée. De façon complémentaire, le module électronique peut être différent pour cette ou ces voies de mesure, apportant également une dissimilarité technologique.

Le bus numérique peut être par exemple d'un type connu choisi parmi les types TIA/EIA-485, TIA/EIA-422, ARINC 429, CAN bus, I2C, AFDX, Time-Triggered Ethernet, FlexRay, LIN ou MIL-STD-1553.

Selon une possibilité compatible avec les précédentes, au moins une des voies de mesure peut comporter une mémoire dans laquelle est stockée au moins une loi de calibration, et ledit au moins un calculateur duplex est configuré pour appliquer une calibration de la valeur de transfert portée par le signal numérique de transfert pour chaque voie de mesure à l'aide de ladite au moins une loi de calibration.

Il est en effet connu que la valeur mesurée par le capteur peut être modifiée ou peut dériver avant sa transmission par le système de mesure d'effort. Cette dérive peut être liée à divers facteurs tels que la tension électrique, la température et/ou le vieillissement de chaque voie de mesure par exemple. Des erreurs peuvent également être introduites par des dérives des composants électroniques utilisés sur les voies de mesure, voire par le capteur.

De la sorte, la valeur mesurée par le capteur et portée par le signal analogique de mesure peut être différente de la valeur de transfert portée par le signal numérique de transfert.

La calibration permet ainsi d'améliorer la précision de la valeur de transfert représentative de l'effort dans la chaîne mécanique de commande de vol pour chaque voie de mesure.

Les modifications ou dérives à corriger peuvent être déterminées par calculs, essais ou simulations et implémentées dans la ou les lois de calibration. Selon la complexité des corrections à apporter, la loi de calibration peut comporter une unique formule de calibration, une table comportant plusieurs formules de calibration, ou encore une table de calibration.

La formule de calibration unique donne une valeur corrigée représentative de l'effort en fonction de la valeur de transfert. La table de formules de calibration comporte plusieurs formules, la formule à appliquer pour obtenir la valeur corrigée représentative de l'effort étant définie en fonction de la valeur de transfert. La table de calibration comporte un tableau de correspondance entre des valeurs de transfert et des valeurs corrigées.

Par ailleurs, la loi de calibration peut être générique et identique pour toutes les voies de mesure. Alternativement, la loi de calibration peut être spécifique à chacune des voies de mesure, en particulier lorsqu'elles sont dissimilaires, et de fait différentes d'une voie de mesure à l'autre.

Ledit au moins un calculateur duplex de l'actionneur peut ainsi appliquer la calibration sur chaque voie de commande et de surveillance afin de corriger la valeur de transfert portée par le signal numérique de transfert reçu de chaque voie de mesure, ladite au moins une voie de mesure comportant la mémoire transférant ladite au moins une loi de calibration au calculateur duplex.

Alternativement, cette calibration peut être effectuée par le système de mesure d'effort, et par chaque voie de mesure, avant émission du signal numérique de transfert.

De façon alternative, l'actionneur peut comporter au moins une mémoire dans laquelle sont stockées la ou les lois de calibration, et ledit au moins un calculateur duplex est configuré pour appliquer une calibration de la valeur de transfert portée par le signal numérique de transfert pour chaque voie de mesure à l'aide de ladite au moins une loi de calibration.

Dans ce cas, la ou les lois de calibration peuvent être stockées dans au moins une mémoire dudit au moins un calculateur duplex de l'actionneur, les voies de mesure ne stockant aucune loi de calibration.

Par exemple, en présence d'un unique calculateur duplex, chaque voie de commande et de surveillance de ce calculateur duplex peut comporter une mémoire stockant la ou les lois de calibration, ce calculateur duplex appliquant une telle loi de calibration à la valeur de transfert portée par le signal numérique de transfert circulant dans la voie de commande et la voie de surveillance de ce calculateur duplex.

Selon une possibilité compatible avec les précédentes, l'actionneur peut comporter deux moteurs électriques et deux calculateurs duplex, le système de mesure d'effort comportant deux premières voies de mesure reliées aux voies de commande des deux calculateurs duplex et deux deuxièmes voies de mesure reliées aux voies de surveillance des deux calculateurs duplex, les premières voies de mesure étant dissimilaires des deuxièmes voies de mesure.

L'utilisation de deux calculateurs duplex associés à quatre voies de mesure du système de mesure d'effort permet ainsi d'obtenir un dispositif quadruplex susceptible de pallier des pannes, tant au niveau d'une voie de mesure du système de mesure d'effort que d'une voie de commande ou de surveillance d'un calculateur duplex. De plus, l'utilisation de voies de mesure dissimilaires, selon si elles sont reliées aux voies de commande ou de surveillance des calculateurs duplex, permet de limiter la sensibilité du système de mesure d'effort à certaines pannes.

La chaîne mécanique de commande de vol selon l'invention permet ainsi d'améliorer la tenue à une panne du système de mesure d'effort et/ou de l'actionneur. En particulier, la chaîne mécanique de commande de vol selon l'invention peut ainsi atteindre un niveau de sécurité élevé, correspondant par exemple à un taux d'occurrence de panne inférieur ou égal à 10⁻¹⁰ par heure de vol.

L'invention a également pour objet un aéronef muni d'au moins une gouverne aérodynamique mobile pour diriger cet aéronef et comportant au moins une chaîne mécanique de commande de vol tel que précédemment décrite pour piloter cette gouverne aérodynamique.

L'invention a encore pour objet un procédé de mesure d'une valeur représentative d'un effort dans une chaîne mécanique de commande de vol d'un aéronef à l'aide d'un système de mesure d'effort.

Ce procédé de mesure est remarquable en ce que le système de mesure d'effort est muni d'au moins deux voies de mesure comportant chacune un capteur agencé sur une bielle de la chaîne de commande de vol, un module électronique et une interface de sortie, le procédé comportant les étapes suivantes appliquées pour chaque voie de mesure du système de mesure d'effort :
- génération d'un signal analogique de mesure à l'aide du capteur,
- numérisation du signal analogique de mesure pour former un signal numérique de mesure à l'aide du module électronique,
- transformation du signal numérique de mesure en un signal numérique de transfert à l'aide du module électronique, le signal numérique de transfert étant porteur d'une valeur de transfert représentative de l'effort dans la chaîne mécanique de commande de vol,

- émission par le module électronique du signal numérique de transfert via l'interface de sortie de la voie de mesure, et
- une calibration de ladite valeur de transfert par application d'une loi de calibration, ladite loi de calibration comportant une formule de calibration unique, une table de formules de calibration, ou une table de calibration,
sur au moins une voie de mesure, ladite numérisation étant réalisée par une modulation delta-sigma cadencée par une horloge, ladite transformation étant réalisée par un codage Manchester et une transmission différentielle basse-tension.

Le procédé selon l'invention applique ainsi des traitements au signal analogique de mesure porteur d'une valeur mesurée fonction de l'effort dans la chaîne mécanique de commande de vol d'un aéronef afin de le numériser, puis de modifier le signal numérique de mesure obtenu pour obtenir le signal numérique de transfert porteur de la valeur de transfert qui est émis en direction d'un équipement, et par exemple d'un actionneur série ou parallèle de la chaîne mécanique de commande de vol.

Suite à ces traitements, la valeur de transfert est moins sensible, voire immune à un environnement électromagnétique et plus précise comparée aux solutions actuelles de mesure d'effort, en se prémunissant des pertes de précision liées à la transmission de signaux purement analogiques et des potentielles introductions de bruit dues à des perturbations. L'utilisation d'une modulation delta-sigma contribue également à une bonne précision de la valeur représentative de l'effort.

Ce procédé peut notamment être mise en œuvre par la chaîne mécanique de commande de vol précédemment décrite.

L'invention et ses avantages apparaîtront avec plus de détails dans le cadre de la description qui suit avec des exemples donnés à titre illustratif en référence aux figures annexées qui représentent :
- la figure 1, une vue d'une chaîne mécanique de commande de vol selon l'invention,
- la figure 2, une vue d'un aéronef comportant la chaîne mécanique de commande de vol de la figure 1
- la figure 3, une vue partielle de la chaîne mécanique de commande de vol de la figure 1, et
- la figure 4, une vue partielle de la chaîne mécanique de commande de vol de la figure 1.

Les éléments présents dans plusieurs figures distinctes sont affectés d'une seule et même référence.

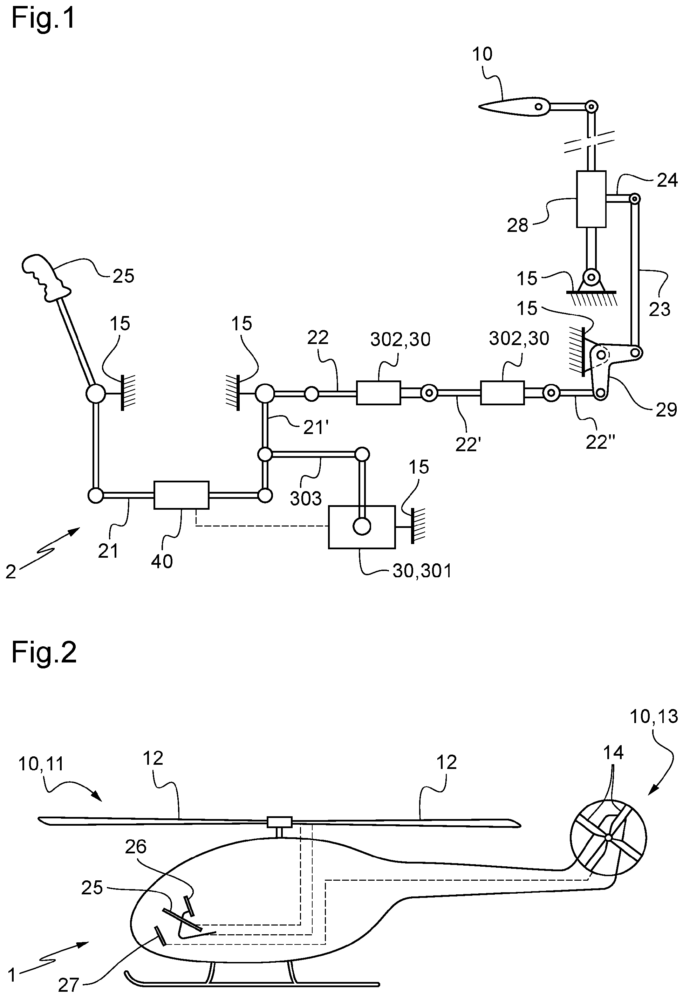

La figure 1 présente une chaîne mécanique de commande de vol 2 pour un aéronef 1.

Une telle chaîne mécanique de commande de vol 2 commande, éventuellement via une servocommande 28, des mouvements d'une ou de plusieurs gouvernes aérodynamiques 10 permettant de diriger l'aéronef 1. De telles gouvernes aérodynamiques 10 peuvent comprendre des premières pales 12 d'un rotor principal 11, des secondes pales 14 d'un rotor de contrôle du mouvement en lacet 13, voire des pales d'hélices, des volets de profondeur ou de direction.

Selon l'exemple de la figure 2, l'aéronef 1 peut être un hélicoptère comprenant un rotor principal 11 muni de premières pales 12 à pas variable et d'un rotor de contrôle du mouvement en lacet 13 muni de secondes pales 14 à pas variable. Dans ce cas, l'aéronef 1 peut comporter plusieurs chaînes mécaniques de commande de vol 2 commandant respectivement à l'aide d'un levier 25 de pas collectif une variation collective du pas des premières pales 11, à l'aide d'un manche 26 de pas cyclique une variation cyclique du pas des premières pales 12, et à l'aide d'un palonnier 27 une variation collective du pas des secondes pales 14.

Indépendamment de la nature des gouvernes aérodynamiques 10, la chaîne mécanique de commande de vol 2 comprend qu'un organe de pilotage 25,26,27 et plusieurs bielles 21,21',22,22',22'',23,24 articulées entre elles, éventuellement par l'intermédiaire d'un guignol 29 voire d'un combinateur. La chaîne mécanique de commande de vol 2 comporte également un ou plusieurs actionneurs 30, ainsi qu'un système de mesure d'effort 40. La référence « 30 » désigne n'importe lequel des actionneurs d'une chaîne mécanique de commande de vol 2, les références « 301, 302 » désignant des actionneurs spécifiques si besoin.

Selon l'exemple de la figure 1, une chaîne mécanique de commande de vol 2 peut comporter au moins un actionneur parallèle 301 et au moins un actionneur série 302.

L'actionneur parallèle 301 relie, selon l'exemple illustré, une bielle 21' de la chaîne mécanique de commande de vol 2, par l'intermédiaire d'une bielle de liaison 303, à un point fixe de la structure 15. Cet actionneur parallèle 301 peut comporter par exemple un vérin ou un moteur électrique.

Selon l'exemple illustré, deux actionneurs série 302 peuvent relier respectivement deux des bielles 22,22',22'' de la chaîne mécanique de commande de vol 2 par une de leurs extrémités respectives. Ces actionneurs série 302 peuvent comporter par exemple chacun un vérin électrique.

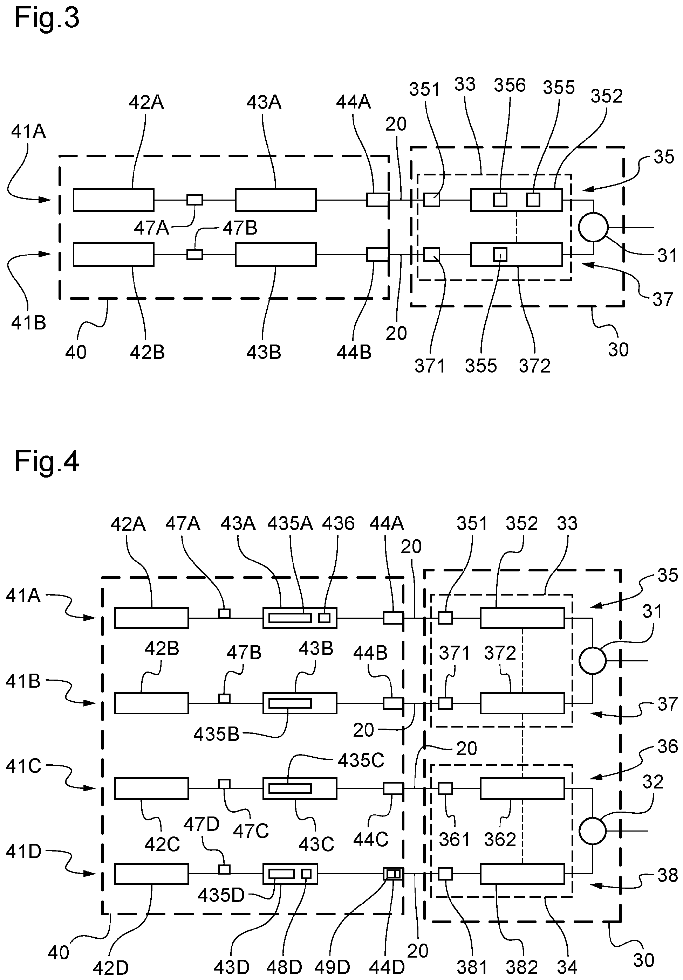

Indépendamment de son type et comme représenté sur les figures 3 et 4, l'actionneur 30 comporte au moins un moteur électrique 31,32 et un calculateur duplex 33,34 par moteur 31,32. Chaque calculateur duplex 33,34 est muni de deux voies de calcul indépendantes, à savoir une voie de commande 35,36 et une voie de surveillance 37,38, ainsi qu'une interface d'entrée 351,361,371,381 par voie de calcul 35,36,37,38.

Chaque voie de calcul 35,36,37,38 comporte une unité de traitement 352,362,372,382 pouvant comprendre par exemple un processeur, au moins un circuit intégré, au moins un circuit logique, ces exemples ne limitant pas la portée donnée à l'expression « unité de traitement ». Le terme processeur peut désigner aussi bien une unité centrale de traitement connue sous l'acronyme CPU, une unité graphique de traitement GPU, une unité digitale connue sous l'acronyme DSP, un microcontrôleur, etc.

Le système de mesure d'effort 40 est agencé dans la chaîne mécanique de commande de vol 2, et par exemple sur une des bielles 21-24. Ce système de mesure d'effort 40 permet en particulier de mesurer directement ou indirectement un effort subi ou transmis par cette bielle 21-24.

Le système de mesure d'effort 40 comporte au moins deux voies de mesure 41, munies chacune d'un capteur 42 agencé sur la bielle 21-24, d'un module électronique 43 et d'une interface de sortie 44. Une référence uniquement numérique « 41 », « 42 », « 43 », « 44 » désigne de façon générale une voie de mesure ou un de ses composants, une lettre « A », « B », « C » ou « D » étant associées à ces références numériques pour désigner une voie de mesure spécifique ou un de ses composants si besoin.

Le module électronique 43 peut par exemple comporter différents composants électroniques, tels que des circuits intégrés, des microcontacts, et/ou des éléments électroniques passifs, reliés entre eux par un circuit imprimé ou un équivalent.

L'interface de sortie 44 de chaque voie de mesure 41 est reliée électriquement, via un harnais électrique 20 à une seule interface d'entrée 351,361,371,381 d'une voie de calcul 35,36,37,38 de l'actionneur 30, chaque interface d'entrée 351,361,371,381 étant reliée à une seule interface de sortie 44.

Le capteur 42 peut comporter par exemple au moins une jauge de contraintes, un capteur piézo-électriques ou un capteur de déplacement linéaires LVDT. Ce capteur 42 permet pour ces exemples de mesurer un déplacement ou une déformation de la bielle 21-24 qui est fonction de, voire proportionnel à, l'effort subi ou transmis par cette bielle 21-24, et par suite l'effort subi ou transmis par la chaîne de commande de vol 2.

Les voies de mesure 41 peuvent éventuellement comporter des capteurs 42 de types différents afin notamment de rendre ces voies de mesure 41 dissimilaires.

Des exemples de réalisation du système de mesure d'effort 40 et de l'actionneur 30 sont représentés sur les figures 3 et 4.

Selon un premier exemple de réalisation représenté sur la figure 3, le système de mesure d'effort 40 comporte deux voies de mesure 41A,41B et l'actionneur 30 comporte un unique calculateur duplex 33. Les deux voies de mesure 41A,41B sont reliées respectivement aux voies de commande 35 et de surveillance 37, via les interfaces de sortie 44A,44B et les interfaces d'entrée 351,371.

L'unité de traitement 352 de la voie de commande 35 du calculateur duplex 33 comporte une horloge 355 et une mémoire 356, l'unité de traitement 372 de la voie de surveillance 37 de ce calculateur duplex 33 comportant également une horloge 355.

Selon un second exemple de réalisation représenté sur la figure 4, le système de mesure d'effort 40 comporte quatre voies de mesure 41A,41B,41C,41D et l'actionneur 30 comporte deux calculateurs duplex 33,34. Les quatre voies de mesure 41A,41B,41C,41D sont reliées respectivement aux voies de commande 35,36 et de surveillance 37,38, via les interfaces de sortie 44A,44B, 44C,44D et les interfaces d'entrée 351,361,371,381.

Le module électronique 43A,43B,43C,43D des quatre voies de mesure 41A,41B,41C,41D comporte une horloge 435A,435B,435C,435D, le module électronique 43A de la première voie de mesure 41A comportant également une mémoire 436.

Selon ce second exemple, les deux voies de mesure 41A,41C qui sont reliées aux voies de commande 35,37 des deux calculateurs duplex 33,34 peuvent être dissimilaires des deux voies de mesure 41B,41D reliées aux voies de surveillance 36,38 des deux calculateurs duplex,33,34.

Indépendamment de ces deux exemples de réalisation, chaque voie de mesure 41 génère grâce au capteur 42 un signal analogique de mesure porteur d'une valeur mesurée fonction de l'effort subi ou transmis dans la chaîne mécanique de commande de vol 2. Le module électronique 43 de chaque voie de mesure 41 reçoit ce signal analogique de mesure et peut lui appliquer divers traitements pour dans un premier temps le numériser afin d'obtenir un signal numérique de mesure porteur d'une valeur numérisée fonction de la valeur mesurée et par suite, de l'effort subi ou transmis dans la chaîne mécanique de commande de vol 2. Dans un second temps, le module électronique 43 transforme le signal numérique de mesure en un signal numérique de transfert porteur de la valeur de transfert fonction de la valeur numérisée et par suite, de l'effort subi ou transmis dans la chaîne mécanique de commande de vol 2.

En particulier, le module électronique 43 d'au moins une des voies de mesure 41, voire de chaque voie de mesure 41, applique une modulation delta-sigma pour numériser le signal analogique de mesure, puis un codage Manchester et une transmission différentielle basse-tension pour obtenir le signal numérique de transfert.

La valeur de transfert ainsi obtenue est précise et relativement immune à un environnement électromagnétique.

Le signal temporel de l'horloge 355,435 est notamment utilisé par les modules électroniques 43 pour la réalisation de la modulation delta-sigma et pour appliquer le codage Manchester. Par ailleurs, lorsque l'horloge 355 est située dans le calculateur duplex 33,34, le signal temporel est transmis à chaque voie de mesure 41 via les interfaces d'entrée 351,361,371,381 et de sortie 44.

En complément d'au moins une des voies de mesure 41A appliquant une modulation delta-sigma, et comme représenté sur la figure 4, le module électronique 43D d'au moins une autre voie de mesure 41D, peut comporter un convertisseur analogique vers numérique 48D pour numériser le signal analogique de mesure et l'interface de sortie 44D de cet au moins une autre voie de mesure 41D comporte alors un bus numérique 49D pour permettre la transformation du signal numérique de mesure en signal numérique de transfert. Cette autre voie de mesure 41D n'applique pas, dans ce cas, la modulation delta-sigma, ni un codage Manchester. La chaîne mécanique de commande de vol 2 selon l'invention comporte ainsi avantageusement au moins deux voies de mesure 41A,41D dissimilaires permettant ainsi de pallier des pannes susceptibles d'affecter les voies de mesure 41.

Par ailleurs, la mémoire 356,436 peut stoker une ou plusieurs lois de calibration. Cette ou ces lois de calibration permettent de corriger des écarts entre la valeur de transfert portée par le signal numérique de transfert et la valeur mesurée par le capteur 42 .

Une première correction apporté par cette ou ces lois de calibration peut être obtenue par l'implémentation d'une calibration dite « statique », fonction uniquement de la valeur de transfert. Une telle calibration statique permet de pallier notamment des erreurs de gain et/ou d'offset intrinsèques à la voie de mesure 41.

Une seconde correction peut être obtenue par l'implémentation d'une calibration dite « dynamique » fonction de la valeur de transfert et de la température de la voie de mesure 41 concernée. Une telle calibration dynamique permet de pallier des erreurs de gain et d'offset liés à la température de la voie de mesure 41. Pour implémenter cette calibration dynamique, un senseur de température 47 peut être intégré sur chaque voie de mesure 41 du système de mesure d'effort 40 pour mesurer la température de chaque voie de mesure 41.

Quelle que soit la correction mise en place, une loi de calibration peut comporter une unique formule de calibration, une table comportant plusieurs formules de calibration, ou encore une table de calibration. La formule de calibration unique donne une valeur corrigée représentative de l'effort en fonction de la valeur de transfert et, le cas échéant de la température de la voie de mesure 41 pour la calibration dynamique.

La table de formules de calibration comporte plusieurs formules, la formule à appliquer pour obtenir la valeur corrigée représentative de l'effort étant définie en fonction de la valeur de transfert et, le cas échéant de la température de la voie de mesure 41 pour la calibration dynamique. Une recherche d'une valeur corrigée proche peut également être effectuée à l'aide d'au moins un algorithme, par exemple par dichotomie, dans le cas où cette table ne fournit pas de formules pour la valeur de transfert courante.

La table de calibration comporte un tableau de correspondance entre des valeurs de transfert et des valeurs corrigées, et le cas échéant en fonction de la température de la voie de mesure 41 pour la calibration dynamique. Là encore, une recherche d'une valeur corrigée proche peut également être effectuée à l'aide d'au moins un algorithme, par exemple par dichotomie, dans le cas où cette table ne fournit pas de valeur corrigée pour la valeur de de transfert courante.

Ainsi, le ou les calculateurs duplex 33,34 de l'actionneur 30 peuvent réaliser une calibration de la valeur de transfert portée par le signal numérique de transfert reçu de chaque voie de mesure 41 à l'aide de la ou les lois de calibration. Alternativement, cette calibration peut être effectuée par le système de mesure d'effort 40, et en particulier par la module électronique 43 pour chaque voie de mesure 41, avant l'émission du signal numérique de transfert.

Selon l'exemple de la figure 3, la première unité de traitement 352 du calculateur duplex 33 de l'actionneur 30 comporte la mémoire 356 dans laquelle sont stockées la ou les lois de calibration. Cette première unité de traitement 352 peut donc appliquer directement la calibration sur la valeur de transfert portée par le signal numérique de transfert reçu par la première voie de commande 35. De plus, la seconde unité de traitement 326 communique avec la première unité de traitement 352 pour recevoir la ou les lois de calibration, afin d'appliquer la calibration sur la valeur de transfert portée par le signal numérique de transfert reçu par la première voie de surveillance 36.

En présence de plusieurs calculateurs duplex 33,34, un seul des calculateurs duplex 33,34 peut comporter la mémoire 352 et transmettre cette ou ces lois de calibration à un ou plusieurs autres calculateurs duplex 33,34 par une liaison filaire ou sans fil. De la sorte, une seule mémoire 352 est suffisante pour les au moins deux calculateurs duplex 33,34, simplifiant au moins un de ces calculateurs duplex 33,34 et limitant également son coût.

Selon l'exemple de la figure 4, seule le premier module électronique 43A comporte la mémoire 436 stockant la ou les lois de calibration. La ou les lois de calibration sont alors transmises à au moins un des calculateurs duplex 33,34 pour réaliser la calibration de la valeur de transfert sur chacune des voies de commande 35,37 et de surveillance 36,38.

En présence de plusieurs calculateurs duplex 33,34, un de ces calculateurs duplex 33,34 peut recevoir la ou les lois de calibration via la voie de mesure 41 la stockant. Ensuite, ce calculateur duplex 33, 34 peut transmettre la ou les lois de calibration à un ou plusieurs autres calculateurs duplex 33,34 par une liaison filaire ou sans fil.

Quelle que soit la correction mise en place, la loi de calibration peut être la même pour toutes les voies de mesure 41. Alternativement, la loi de calibration peut être différente d'une voie de mesure 41 à l'autre, notamment lorsque ces voies de mesure 41 sont dissimilaires.

Dans le cas de lois de calibration spécifiques à chaque voie de mesure 41, une seule voie de mesure 41 peut comporter la mémoire 436 pour stocker toutes les lois de calibration. Alternativement, chaque voie de mesure 41 peut comporter une mémoire 436 stockant la loi de calibration à appliquer spécifiquement pour cette voie de mesure 41. Alternativement, chaque voie de mesure peut comporter une mémoire 436 stockant toutes les lois de calibration relatives à chacune des voies de mesure 41 afin de pallier de la sorte une éventuelle défaillance d'une des mémoires de ces voies de mesure 41.

En outre, la chaîne mécanique de commande de vol 2 peut mettre en œuvre un procédé de mesure d'une valeur représentative d'un effort dans la chaîne mécanique de commande de vol 2 à l'aide d'un système de mesure d'effort 40.

Ce procédé comporte les étapes suivantes appliquées pour chaque voie de mesure 41 du système de mesure d'effort 40 :
Tout d'abord, une génération d'un signal analogique de mesure est effectuée à l'aide du capteur 43 de chacune des voies de mesure 41, ce signal analogique de mesure étant porteur de la valeur mesurée par le capteur 43.

Ensuite, une numérisation de ce signal analogique de mesure est effectuée à l'aide dudit module électronique 43 de chacune des voies de mesure 41 pour former un signal numérique de mesure, porteur de la valeur numérisée.

Une transformation de ce signal numérique de mesure en un signal numérique de transfert est alors effectuée à l'aide du module électronique 43 de chacune des voies de mesure 41, le signal numérique de transfert étant porteur d'une valeur de transfert représentative de l'effort dans la chaîne mécanique de commande de vol 2.

Pour au moins une voie de mesure 41, cette numérisation est réalisée par une modulation delta-sigma cadencée par une horloge, et la transformation est réalisée par un codage Manchester et une transmission différentielle basse-tension.

Une émission dudit signal numérique de transfert vers ladite interface de sortie de ladite voie de mesure est effectuée, par exemple à destination de l'actionneur 30, via ces interfaces d'entrée 351,361,371,381.

Enfin, une calibration de la valeur de transfert peut être réalisée par application d'une loi de calibration, cette loi de calibration comportant une formule de calibration unique, une table de formules de calibration, ou une table de calibration.

Cette calibration peut être implémentée indifféremment au sein du ou des calculateurs duplex 33,44 de l'actionneur 30 ou bien des modules électroniques 43 des voies de mesure 41 du système de mesure d'effort 40.

Naturellement, la présente invention est sujette à de nombreuses variations quant à sa mise en œuvre. Bien que plusieurs modes de réalisation aient été décrits, on comprend bien qu'il n'est pas concevable d'identifier de manière exhaustive tous les modes possibles. **Il** est bien sûr envisageable de remplacer un moyen décrit par un moyen équivalent sans sortir du cadre de la présente invention défini par les revendications.

## Revendications

1. Chaîne mécanique de commande de vol (2) d'un aéronef (1), comportant au moins une bielle (21-24) et un actionneur (30), ledit actionneur (30) comportant au moins un moteur électrique (31,32) et un calculateur duplex (33,34) par moteur (31,32), chaque calculateur duplex (33,34) comportant une voie de commande (35,37), une voie de surveillance (36,38) et deux interfaces d'entrée (351,361,371,381) reliées respectivement à ladite voie de commande (35,37) et à ladite voie de surveillance (36,38), ladite chaîne mécanique de commande de vol (2) comportant un système de mesure d'effort (40) agencé sur ladite bielle (21-24) et configuré pour contrôler ledit actionneur (30),
**caractérisée en ce que** ledit système de mesure d'effort (40) comporte au moins deux voies de mesure (41) reliées respectivement auxdites deux interfaces d'entrée (351,361,371,381) dudit au moins un calculateur duplex (33,34) et chacune desdites voies de mesure (41) comporte un capteur (42), un module électronique (43) et une interface de sortie (44), ladite interface de sortie (44) étant reliée à une desdites interfaces d'entrée (351,361,371,381) dudit au moins un calculateur duplex (33,34), ledit module électronique (43) étant relié audit capteur (42) pour générer un signal analogique de mesure, ledit module électronique (43) étant configuré pour effectuer une numérisation dudit signal analogique de mesure pour le transformer en un signal numérique de mesure, ledit module électronique (43) étant configuré pour effectuer une transformation dudit signal numérique de mesure en un signal numérique de transfert porteur d'une valeur de transfert représentative d'un effort dans ladite chaîne mécanique de commande de vol (2), au moins une desdites voies de mesure (41) appliquant une modulation delta-sigma pour numériser ledit signal analogique de mesure et appliquant un codage Manchester et une transmission différentielle basse-tension pour transformer ledit signal numérique de mesure en ledit signal numérique de transfert, ladite chaîne mécanique de commande de vol (2) comportant une horloge (355,435) par voie de mesure destinée à cadencer ladite modulation delta-sigma.

2. Chaîne mécanique de commande de vol (2) selon la revendication 1,
dans laquelle ledit capteur (42) comporte au moins une jauge de contraintes, un capteur piézo-électriques ou un capteur de déplacements linéaires.

3. Chaîne mécanique de commande de vol (2) selon l'une quelconque des revendications 1 à 2,
dans laquelle ledit système de mesure d'effort (40) ou ledit actionneur (30) comporte lesdites horloges (355,435).

4. Chaîne mécanique de commande de vol (2) selon l'une quelconque des revendications 1 à 3,
dans laquelle, pour au moins une des voies de mesure (41), ledit module électronique (43) comporte un convertisseur analogique vers numérique (48) et ladite interface de sortie (44) comporte un bus numérique (49).

5. Chaîne mécanique de commande de vol (2) selon l'une quelconque des revendications 1 à 4,
dans laquelle au moins une desdites voies de mesure (41) comporte une mémoire (436) dans laquelle est stockée au moins une loi de calibration, et ledit au moins un calculateur duplex (33,34) est configuré pour appliquer une calibration de ladite valeur de transfert portée par ledit signal numérique de transfert pour chaque voie de mesure (41) à l'aide de ladite au moins une loi de calibration.

6. Chaîne mécanique de commande de vol (2) selon l'une quelconque des revendications 1 à 5,
dans laquelle ledit actionneur (30) comporte au moins une mémoire (356) dans laquelle est stockée au moins une loi de calibration, et ledit au moins un calculateur duplex (33,34) est configuré pour appliquer une calibration de ladite valeur de transfert portée par ledit signal numérique de transfert pour chaque voie de mesure (41) à l'aide de ladite au moins une loi de calibration.

7. Chaîne mécanique de commande de vol (2) selon l'une quelconque des revendications 1 à 6,
dans laquelle ledit actionneur (30) comporte deux moteurs électriques (31,32) et deux calculateurs duplex (33,34), ledit système de mesure d'effort (40) comportant deux premières voies de mesure (41A,41C) reliées auxdites voies de commande (35,37) desdits deux calculateurs duplex (33,34) et deux deuxièmes voies de mesure (41B,41D) reliées auxdites voies de surveillance (36,38) desdits deux calculateurs duplex (33,34), lesdites premières voies de mesure (41A,41C) étant dissimilaires desdites deuxièmes voies de mesure (41B,41D).

8. Aéronef (1) muni d'au moins une gouverne aérodynamique (10) mobile pour déplacer ledit aéronef (1), et d'au moins une chaîne mécanique de commande de vol (2) selon l'une quelconque des revendications 1 à 7 pour piloter ladite gouverne aérodynamique (10).

9. Procédé de mesure d'une valeur représentative d'un effort dans une chaîne mécanique de commande de vol (2) d'un aéronef (1) à l'aide d'un système de mesure d'effort (40),
**caractérisé en ce que**, ledit système de mesure d'effort (40) étant muni d'au moins deux voies de mesure (41) comportant chacune un capteur (42) agencé sur une bielle (21-24) de ladite chaîne mécanique de commande de vol (2), un module électronique (43) et une interface de sortie (44), ledit procédé comporte les étapes suivantes appliquées pour chaque voie de mesure (41) dudit système de mesure d'effort (40) :
- génération d'un signal analogique de mesure à l'aide dudit capteur (42),
- numérisation dudit signal analogique de mesure pour former un signal numérique de mesure à l'aide dudit module électronique (43),
- transformation dudit signal numérique de mesure en un signal numérique de transfert à l'aide dudit module électronique (43), ledit signal numérique de transfert étant porteur d'une valeur de transfert représentative dudit effort dans ladite chaîne mécanique de commande de vol (2), et
- émission par ledit module électronique (43) dudit signal numérique de transfert vers ladite interface de sortie (44) de ladite voie de mesure (41), et
- une calibration de ladite valeur de transfert par application d'une loi de calibration, ladite loi de calibration comportant une formule de calibration unique, une table de formules de calibration, ou une table de calibration,
sur au moins une voie de mesure, ladite numérisation étant réalisée par une modulation delta-sigma cadencée par une horloge (355,435), ladite transformation étant réalisée par un codage Manchester et une transmission différentielle basse-tension.
